Europäisches Patentamt

European Patent Office

Office européen des brevets

(19)

(11) Veröffentlichungsnummer: **0 317 802**
**A1**

# (12) EUROPÄISCHE PATENTANMELDUNG

(21) Anmeldenummer: 88118294.3

(22) Anmeldetag: 03.11.88

(51) Int. Cl.4: **H01L 29/10** , **H01L 29/72** ,
**H01L 21/265**

(30) Priorität: 25.11.87 CH 4595/87

(43) Veröffentlichungstag der Anmeldung:
**31.05.89 Patentblatt 89/22**

(84) Benannte Vertragsstaaten:
**CH DE FR GB IT LI NL SE**

(71) Anmelder: **BBC Brown Boveri
Aktiengesellschaft**

**CH-5401 Baden(CH)**

(72) Erfinder: **Grüning, Horst, Dr.
Im Ergel 10
CH-5404 Baden(CH)**
Erfinder: **Voboril, Jan
Landschreiberstrasse 2
CH-5415 Nussbaumen(CH)**

(54) **Abschaltbares Leistungshalbleiterbauelement sowie Verfahren zu dessen Herstellung.**

(57) Bei einem Feldgesteuerten Thyristor (FCTh) mit recessed-gate-Struktur und Langkanalsteuerung wird der abschaltbare Strom erhöht, indem die Gatebereiche (8) auf den Grabenböden unabhängig von den Wandschichten (14) $p^+$-dotiert ausgeführt werden.

Der auf diese Weise reduzierte Gatewiderstand ermöglicht höhere Gateströme, ohne die Steuerung im Kathodenfinger (7) zu beeinträchtigen und den Durchlasswiderstand zu erhöhen.

Die selektive Dotierung der Gatebereiche wird entweder mittels senkrechter "Überhangsmaske-Ionenimplantation und nachfolgenden Drive-In-Schrittes oder mittels schräger Doppelionenimplantation, wobei "Überhangsmasken oder Masken, die die Grabenwände abdecken verwendet werden, durchgeführt.

Fig.3A

# ABSCHALTBARES LEISTUNGSHALBLEITERBAUELEMENT SOWIE VERFAHREN ZU DESSEN HERSTELLUNG

## TECHNISCHES GEBIET

Die Erfindung bezieht sich auf das Gebiet der Halbleiterbauelemente. Sie betrifft insbesondere ein abschaltbares Leistungshalbleiterbauelement in Form eines Feldgesteuerten Thyristors (FCTh = Field Controlled Thyristor) mit einer Anode, einer Kathode und einem Gate, umfassend zwischen der Anode und der Kathode

- eine p-leitende Anodenschicht;
- eine darüberliegende n-leitende Kanalschicht; und
- eine Mehrzahl von auf der Kathodenseite abwechselnd angeordneten n-leitenden Kathodenbereichen und p-leitenden Gatebereichen, wobei
- die Kathodenbereiche auf durch Gräben voneinander getrennten Kathodenfingern angeordnet sind,
- die Gatebereiche sich über die Böden der Gräben erstrecken; und
- im Bereich der Grabenwände zusätzlich p-leitende, p-dotierte Wandschichten vorgesehen sind, welche mit den Gatebereichen in Verbindung stehen, und in jedem Kathodenfinger mit dem dortigen Bereich der Kanalschicht einen feldeffektsteuerbaren Langkanal bilden.

Die Erfindung betrifft weiterhin ein Verfahren zu dessen Herstellung, bei welchem Verfahren zunächst durch anisotropes Aetzen in einem Halbleitersubstrat die Gräben erzeugt und anschliessend in die Grabenböden die Gatebereiche eingebracht werden.

Ein Bauelement sowie ein Verfahren der eingangs genannten Art sind z.B. aus der EP-A2-0 178 387 bekannt.

## STAND DER TECHNIK

Feldgesteuerte Leistungshalbleiterbauelemente sind mit unterschiedlichen Strukturen und unter verschiedenen Bezeichnungen bekannt. Innerhalb dieser Gruppe von bekannten Bauelementen werden im wesentlichen zwei Funktionstypen unterschieden, nämlich unipolare Strukturen wie z.B. Feldeffekttransistoren vom MOSFET- oder JFET-Typ mit Majoritätsträgerleitung, sowie Bauelemente mit bipolarer Trägerinjektion wie z.B. der feldgesteuerte Thyristor FCTh (Field Controlled Thyristor) oder der statische Induktionsthyristor SITh (Static Induction Thyristor).

Für Anwendungen im Bereich hoher Leistungen sind aus physikalischen Gründen vor allem die letztgenannten bipolaren Strukturen von Interesse, deren Wirkungsweise in der eingangs genannten Druckschrift dargestellt ist.

Diese Wirkungsweise der bekannten Strukturen beruht in der Regel auf der Anwendung des JFET (Junction Field Effect Transistor)-Prinzips für die Steuerung: In fein verteilten, mit Kathodenbereichen abwechselnden Gate- oder Steuerzonen werden durch Anlegen einer entsprechenden Gatespannung durch den Aufbau einer sich ausbreitenden Raumladungszone Gebiete mit Ladungsträgerverarmung erzeugt, die sich mit steigender Gatespannung in ein den Strom leitendes Kanalgebiet ausdehnen und schliesslich durch Abschnürung des Kanalgebiets den Stromfluss unterbrechen bzw. abschalten.

Der bekannte feldgesteuerte Thyristor befindet sich bei fehlender Gatespannung im Durchlasszustand (ON-Zustand) und wird erst durch Anlegen einer geeigneten Gatespannung abgeschaltet. Für die Dimensionierung und den Aufbau einer solchen Thyristorstruktur bedeutet dies, dass im Durchlasszustand ein möglichst geringer Durchlasswiderstand (ON-Widerstand) erwünscht ist, um die bei vollem Stromfluss am Bauelement abfallende Leistung zu begrenzen. Andererseits sollte die Gate-Kathoden-Struktur des Bauelements so ausgelegt sein, dass eine möglichst gute Steuerbarkeit erreicht wird, d.h. mit kleinen Gatespannungen und -strömen hohe Leistungen geschaltet werden können.

Ausgehend von einer aus der EP-A1-0 121 068 bekannten Struktur eines FCTh, bei der die p-dotierten Gatebereiche auf den Böden der Gräben angeordnet sind, welche die einzelnen Kathodenfinger voneinander trennen, ist in der EP-A2-0 178 387 vorgeschlagen worden, die p-dotierten Gatebereiche auf die Grabenwände auszudehnen, um so eine Verbesserung der Blockierverstärkung und damit der Steuerbarkeit des FCTh zu erreichen. Eine vergleichbare Struktur ist auch aus der US-PS 4,037,245 bekannt.

Mit diesen auf die Grabenwände erweiterten Gatebereichen wird eine Feldsteuerung über die gesamte Tiefe des im Kathodenfinger verlaufenden Kanals erzielt (feldeffektsteuerbarer Langkanal). Dadurch ist ein Abschalten des jeweiligen Kathodenfingers bei hinreichend kleinen Gatespannungen gewährleistet.

Die mit den erweiterten Gatebereichen erzielte Verbesserung in den Steuereigenschaften bringt für das Durchlassverhalten des Thyristors allerdings Probleme mit sich: Im ON-Zustand wird der $n^-$-dotierte Kanal im Kathodenfinger nicht mit Ladungsträgern überschwemmt, da die von der Anode injizierten Löcher über die relativ gut leitenden p-dotierten Gatebereiche in den Grabenwänden abfliessen.

Aus dieser Ladungsträger-Verarmung im Kanalgebiet resultiert ein hoher ON-Widerstand, obgleich die Gateelektrode nicht auf festem Potential liegt ("floating Gate").

Einen noch wirksameren Löcher-Bypass und damit noch schlechtere Durchlasseigenschaften erhält man, wenn die Gatebereiche $p^+$-dotiert sind, wie dies in der US-PS 4,571,815 vorgeschlagen ist.

Eine Reduzierung der p-Dotierung in den Gatebereichen würde andererseits zwar den Widerstand des Bypasses erhöhen und damit die Durchlasseigenschaften verbessern. Zugleich wird aber auch der Widerstand des Gates erhöht, so dass die Gateströme und damit der abschaltbare Anodenstrom verringert werden.

Um diesen Problemen abzuhelfen, ist in der älteren Europäischen Patentanmeldung Nr. 87107918.2 (entsprechend der US-Anmeldung Serial No. 07/051 865) vorgeschlagen worden, die p-Dotierung der Gatebereiche in den Grabenböden beizubehalten und die entsprechenden Schichten in den Grabenwänden, die Wandschichten, so zu modifizieren, dass ein Abfluss der Löcher über die Grabenwände weitgehend vermieden wird.

Eine dieser Modifikationen sieht vor, den Widerstand der Wandschichten durch eine Reduzierung der Schichtdicke oder der Dotierung (auf z.B. $3 \cdot 10^{15}$ cm$^{-3}$) zu erhöhen.

Eine andere Modifikation sieht in den Grabenwänden flächenhafte npn-Transistorstrukturen vor, die sich aus der n-leitenden Kanalschicht im Kathodenfinger, der p-leitenden Wandschicht und dem n-leitenden Kathodenbereich ergeben, der an den Grabenwänden herabgezogen ist und die Wandschichten überdeckt.

Experimente mit derartigen Bauelementen haben nun die folgenden Ergebnisse gebracht:

(1) Durch die Ausbildung eines feldeffektsteuerbaren Langkanals in den Kathodenfingern wird das sogenannte dynamische Latching, d.h. das ungewollte Durchschalten des Bauelements kurz nach dem Abschalten, sicher vermieden (siehe dazu auch: H. Grüning et al., International Electron Devices Meeting IEDM 1986, pp. 110).

(2) Eine Rand-Dotierungskonzentration der Gatebereiche gemäss der o.g. älteren Anmeldung von etwa $4 \cdot 10^{16}$ cm$^{-3}$ reicht aus, um die Avalanche-Feldstärke zu blockieren, so dass derartige FCThs tatsächlich bis zur absoluten Grenze des dynamischen Avalanche betrieben werden können.

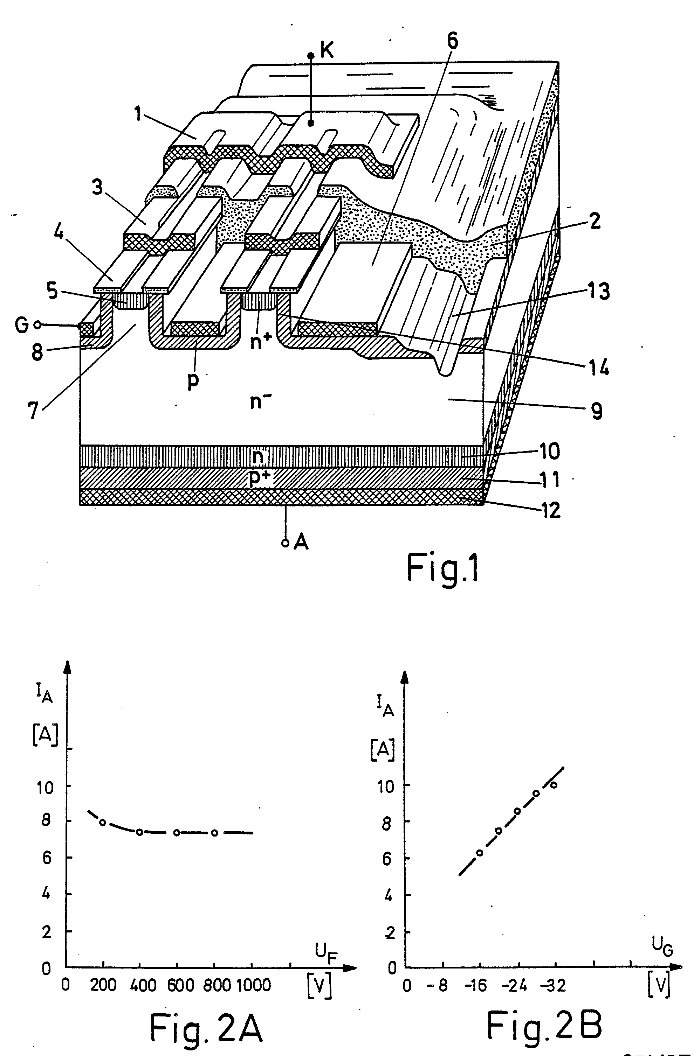

(3) Die mit dem Bauelement abschaltbare Stromdichte ist aber auch bei kleinen Spannungen auf ca. 200 A/cm$^2$ begrenzt, weil der Gatekontakt bei der genannten Dotierungskonzentration und üblicher Gatespannung nicht mehr Strom trägt. Dies äussert sich in einem Einsatz des Latchings, der von der Anodenspannung $U_A$ praktisch unabhängig ist (Fig. 2A), und lediglich von der angelegten Gatespannung $U_G$ bestimmt wird (Fig. 2B).

(4) Beim Parallelschalten von FCThs und bei Vergrösserung der Bauelementfläche ist das gleichzeitige Abschalten aller durch die Kathodenfinger bestimmten Segmente von besonderer Wichtigkeit, weil sich sonst der Strom auf kleinere Flächen konzentriert.

(5) FCThs reagieren auf grösseren Abschaltstrom mit erhöhter Abschaltgeschwindigkeit (z.B. von 8,8 KV/µs bei 800 V/6A auf 13 kV/µs bei 800 V/10A). Deshalb gleichen sich anfängliche Inhomogenitäten in der Stromverteilung, die durch kleine Zeitunterschiede in der Ansteuerung der einzelnen Segmente verursacht wurden, während des Abschaltvorgangs wieder aus. Voraussetzung aber ist, dass jedes Segment zu Beginn des Abschaltvorganges auch gegen erhöhte Stromdichte sicher abgeschaltet werden kann.

Insbesondere die unter (3) - (5) aufgeführten Ergebnisse lassen erkennen, dass die Belastungsgrenzen der bisherigen Bauelemente wesentlich von der Qualität des Gatekontaktes bestimmt werden.

## DARSTELLUNG DER ERFINDUNG

Aufgabe der vorliegenden Erfindung ist es nun, den FCTh gateseitig so zu verbessern, dass zugleich seine Leistungsfähigkeit steigt, und ein sicheres Abschalten gewährleistet ist.

Die Aufgabe wird bei einem Bauelement der eingangs genannten Art dadurch gelöst, dass die p-leitenden Gatebereiche $p^+$-dotiert sind.

Während also bei den bisher bekannten FCThs mit Langkanalsteuerung stets die Gatebereiche und die Wandschichten dieselbe Dotierung aufwiesen und in einem Prozessschritt zusammen hergestellt wurden, wird bei der vorliegenden Erfindung dieser Zusammenhang aufgehoben: Die Wandschichten und die Gatebereiche können dadurch getrennt hinsichtlich ihrer jeweiligen Aufgabe optimiert werden.

Als besonders vorteilhaft hat sich für einen guten Gatekontakt eine Rand-Dotierungskonzentration der Gatebereiche von mehr als $10^{18}$ cm$^{-3}$, vorzugsweise etwa $10^{19}$ cm$^{-3}$ erwiesen.

Gemäss einem bevorzugten Ausführungsbeispiel der Erfindung reichen die Wandschichten von den Grabenwänden bis in das Innere der Kathodenfinger und sind in ihrer Dicke und Dotierungskonzentration derart dimensioniert, dass bei Vollast weniger als 1/3 des Löcherstroms, der in den Kathodenfingern ankommt, über die Wandschichten zur Kathode des Bauelements abgeführt wird, und beim grössten auftretenden elektrischen Feld die Ladungsträger aus den Wandschichten noch nicht vollständig ausgeräumt sind.

Damit ist gewährleistet, dass das Bauelement im ON-Zustand ohne Löcher-Bypass einen sehr kleinen Durchgangswiderstand aufweist.

Dies kann besonders einfach dadurch erreicht werden, dass die Kathodenfinger jeweils eine Breite von etwa 30 μm aufweisen, die Gräben jeweils etwa 35 μm tief sind, und die Wandschichten jeweils eine Dicke von etwa 4 μm und eine Rand-Dotierungskonzentration von etwa $3 \cdot 10^{15}$ cm$^{-3}$ aufweisen.

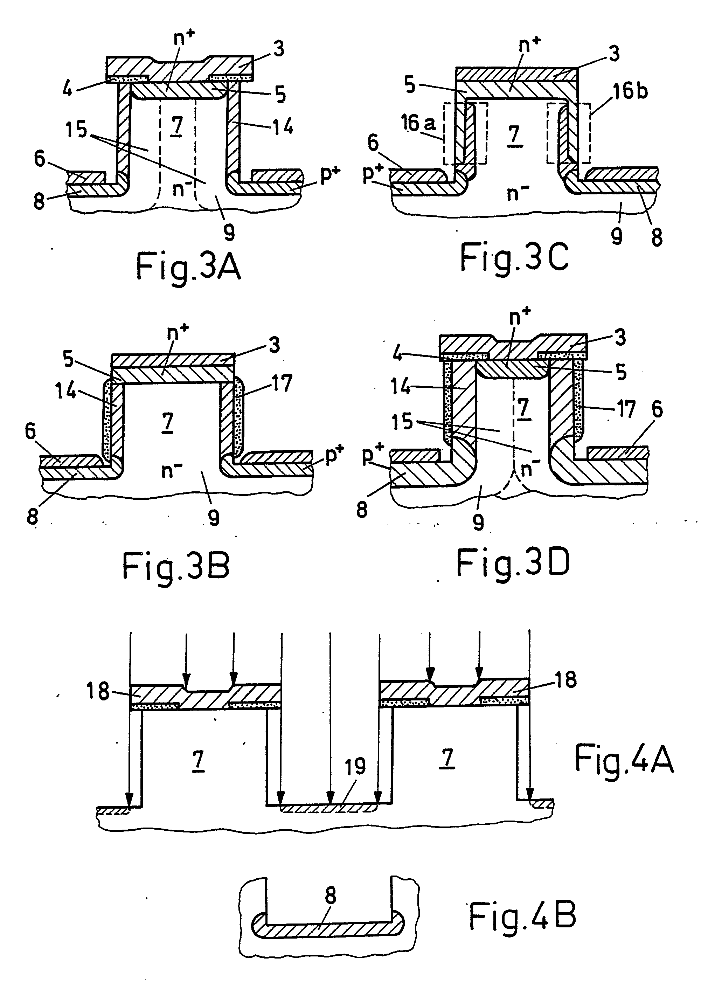

Gemäss einem weiteren bevorzugten Ausführungsbeispiel wird die Optimierung des Durchgangswiderstandes dadurch bewirkt, dass die Wandschichten von den Gatebereichen ausgehend nur bis in die Nähe der auf den Kathodenfingern befindlichen Kathodenbereiche reichen, und die Kathodenbereiche derart erweitert sind, dass sie sich, eingelassen in die Wandschichten, über die Grabenwände bis in die Nähe der Gatebereiche erstrecken und zusammen mit den Wandschichten und den darunterliegenden Gebieten der Kanalschicht Transistorstrukturen bilden, welche sich über die Fläche der Grabenwände erstrecken (Fig. 3C).

Die Erfindung kann sowohl auf FCThs angewendet werden, die bei Kurzschluss zwischen Gate und Kathode im Durchlasszustand sind (normally-ON-FCThs), als auch auf FCThs, die unter diesen Bedingungen sperren (normally-OFF-FCThs).

Solche normally-OFF-FCThs, die schaltungstechnische Vorteile haben, erhält man, wenn gemäss einem anderen Ausführungsbeispiel der Erfindung die Raumladungszonen der zwischen den Wandschichten und der Kanalschicht gebildeten pn-Uebergänge soweit in das Innere der Kathodenfinger hineinreichen, dass bei einem Kurzschluss zwischen Gate und Kathode der Stromfluss durch die Kathodenfinger unterbunden ist.

Das erfindungsgemässe Verfahren zeichnet sich dadurch aus, das die Gatebereiche mittels Ionenimplantation, vorzugsweise von Bor, erzeugt werden, und die Grabenwände im Bereich der späteren Wandschichten während des Implantationsvorgangs vor einer Implantation geschützt werden.

Diese Art der Dotierung hat den Vorteil, dass sie sich besonders einfach mit den Prozessschritten für die Herstellung der bekannten FCThs vereinbaren lässt.

Weitere Ausführungsformen der Erfindung ergeben sich aus den Unteransprüchen.

## KURZE BESCHREIBUNG DER ZEICHNUNG

Die Erfindung soll nachfolgend anhand von Ausführungsbeispielen im Zusammenhang mit der Zeichnung näher erläutert werden. Es zeigen:

Fig. 1 in perspektivischer Darstellung den Schnitt durch einen FCTh mit Langkanal-Steuerung nach dem Stand der Technik;

Fig. 2A die Abhängigkeit des maximalen Anodenstroms, der ohne Latching abgeschaltet werden kann, von der Freilaufspannung für einen typischen FCTh mit induktiver Last;

Fig. 2B die entsprechende Abhängigkeit des Anodenstroms von der Gatespannung;

Fig. 3A-D verschiedene Ausführungsformen der Gate-Kathoden-Struktur für einen FCTh nach der Erfindung;

Fig. 5A,B die Verfahrensschritte gemäss einem zweiten Ausführungsbeispiel des Verfahrens nach der Erfindung; und

Fig. 6A,B die entsprechenden Verfahrensschritte gemäss einem dritten Ausführungsbeispiel.

## WEGE ZUR AUSFÜHRUNG DER ERFINDUNG

Die Struktur eines herkömmlichen, realisierten FCTh-Bauelements mit feldeffektsteuerbarem Langkanal, wie es z.B. aus dem Artikel von H. Grüning et al., International Electron Devices Meeting IEDM 1986, pp. 110 bekannt ist, ist im perspektivischen Schnittbild in Fig. 1 wiedergegeben.

Das Bauelement besitzt eine Anode A, eine Kathode K und ein Gate G. Zwischen der Anode A und der Kathode K ist eine Schichtenfolge unterschiedlichen Leitungstyps und unterschiedlicher Dotierung angeordnet.

Diese Schichtenfolge beginnt anodenseitig mit einer p$^+$-dotierten Anodenschicht 11. Auf die Anodenschicht 11 folgt in diesem Beispiel eine n-dotierte Stoppschicht 10, die aber auch weggelassen werden kann. Oberhalb der Stoppschicht 10 liegt eine n$^-$-dotierte Kanalschicht 9, die auf der Kathodenseite in eine stufenförmige Gate-Kathoden-Struktur übergeht.

Die Gate-Kathoden-Sturktur umfasst eine Mehrzahl von abwechselnd angeordneten n$^+$-dotierten Kathodenbereichen 5 und p-dotierten Gatebereichen 8. Die Kathodenbereiche 5 sind auf der Oberseite von Kathodenfingern 7 angeordnet, welche durch Gräben voneinander getrennt sind.

Die Gatebereiche 8 sind in die Böden der Gräben eingelassen und gehen an den Grabenkanten in gleichartige Wandschichten 14 über, die in den Grabenwänden bis zur Oberseite der Kathodenfinger 7 verlaufen und dort die Kathodenbereiche 5 beidseitig einschliessen.

Zugleich werden von den Wandschichten 14 in den Kathodenfingern 7 Gebiete der Kanalschicht 9 eingeschlossen. Diese Konfiguration bildet einen feldeffektsteuerbaren Langkanal, bei dem die Raumladungszonen der pn-Uebergänge, die von der Kanalschicht 9 und den Wandschichten 14 gebildet werden, je nach Vorspannung des Gates G und nach Art eines JFET das stromtragende Gebiet innerhalb der Kathodenfinger mehr oder weniger stark einschnüren.

Wenn der Langkanal von den Raumladungszonen ganz erfüllt ist, können aus dem Kathodenbereich 5 keine Elektronen mehr in die Kanalschicht 9 injiziert werden, zu der Anodenschicht 11 gelangen und dort eine entsprechende Emission von Löchern auslösen: Der FCTh ist dann abgeschaltet. Der lange Kanal in den Kathodenfingern 7 gewährleistet dabei ein sicheres Abschalten auch bei hohen Freilaufspannungen und vergleichsweise kleinen Gatespannungen.

Die Gatebereiche 8 sind auf den Grabenböden mit metallischen Gatekontakten 6 versehen. Entsprechend sind die Kathodenbereiche 5 mit einer Kathodenmetallisierung 3 kontaktiert, die sich jeweils über den gesamten Kathodenfinger 7 erstreckt und von den oben heraustretenden Wandschichten 14 durch Isolierungsschichten 4 (z.B. aus $SiO_2$) elektrisch getrennt ist.

Das ganze Bauelement ist auf der Kathodenseite mit einer Passivierungsschicht 2 abgedeckt, die nur im Bereich der Kathodenfinger 7 längliche Durchbrüche aufweist, durch die der darüberliegende Kathodenkontakt 1 mit der Kathodenmetallisierung 3 in leitender Verbindung steht.

Anodenseitig ist die Anodenschicht 11 mit einem grossflächigen Anodenkontakt 12 versehen. Der Abschluss des Gates G ist in Fig. 1 nur schematisch dargestellt.

Am Rande des Bauelements ist schliesslich ein Randgraben 13 vorgesehen, der die Sperrfestigkeit des Bauelements in üblicher Weise verbessern soll.

Ein derartiges Bauelement, das in den Gatebereichen 8 eine Rand-Dotierungskonzentration von z.B. $4 \bullet 10^{16}$ cm$^{-3}$ aufweist, kann Ströme nur bis zu einer gewissen Grenze abschalten, ohne dass ein Latching eintritt (Latchgrenze).

Diese Latchgrenze ist in Fig. 2A in Abhängigkeit von der Freilaufspannung $U_F$ und in Fig. 2B in Abhängigkeit von der Gatespannung $U_G$ aufgetragen. Die Messpunkte bezeichnen dabei den maximalen Anodenstrom $I_A$, der ohne Latching abgeschaltet werden kann.

Man erkennt aus diesen beiden Figuren unmittelbar, dass bei einer Bauelementkonfiguration gemäss Fig. 1 die Latchgrenze praktisch nicht von der Freilaufspannung abhängt, dagegen deutlich mit zunehmender Gatespannung $U_G$ wächst.

Dies erklärt sich daraus, dass mit den p-dotierten Gatebereichen 8 der gesamte Gateanschluss einen zu hohen Widerstand aufweist. Das Bauelement kann dadurch nicht bis zur absoluten Grenze des dynamischen Avalanche betrieben werden, sondern wird schon vorher in seiner Leistungsfähigkeit begrenzt, weil wegen des hohen Gatewiderstands nicht genügend Abschaltstrom über das Gate abgeführt werden kann.

Erfindungsgemäss wird dieses Problem nun dadurch beseitigt, dass für die Gatebereiche 8 eine $p^+$-Dotierung vorgesehen wird. Die Wandschichten 14 des Langkanals bleiben demgegenüber aber weiterhin p-dotiert oder werden sogar, wie im Folgenden noch erläutert wird, in ihrer Dotierung noch weiter herabgesetzt, um den eingangs erwähnten schädlichen Löcher-Bypass zu beseitigen.

Die Erfindung führt zu einer Gate-Kathoden-Struktur, wie sie, ausschnittsweise für einen Kathodenfinger 7, in verschiedenen Ausführungsbeispielen in den Fig. 3A - 3D dargestellt ist.

Der Kathodenfinger 7 aus Fig. 3A unterscheidet sich von dem bekannten der Fig. 1 im wesentlichen dadurch, dass die Gatebereiche 8 von den Wandschichten 14 dadurch abgesetzt sind, dass sie eine $p^+$-Dotierung aufweisen. Diese $p^+$-Dotierung hat vorzugsweise eine Rand-Dotierungskonzentration von mehr als $10^{18}$ cm$^{-3}$, insbesondere etwa $10^{19}$ cm$^{-3}$.

Mit einer Dotierungskonzentration von $10^{19}$ cm$^{-3}$ kann der Uebergangswiderstand zum Gatekontakt 6 um bis zu 2 Grössenordnungen reduziert werden, so dass sein Einfluss für die Funktion des Bauelements vernachlässigbar ist, und die volle Leistungsfähigkeit der Struktur ausgenutzt werden kann.

Durch gestrichelte Linien angedeutet sind in Fig. 3A weiterhin die Grenzen der Raumladungszonen 15, die von den pn-Uebergängen zwischen den Wandschichten 14 und der Kanalschicht 9 herrühren und in dem dargestellten Beispiel bei Kurzschluss zwischen Gate und Kathode den Langkanal nicht abschnüren. Das Bauelement aus Fig. 3A ist daher ein normally-ON-FCTh.

Eine leicht geänderte Konfiguration, der das bekannte Bauelement aus der EP-A2- 0 178 387 zugrundeliegt, ist in Fig. 3B wiedergegeben. In diesem Fall erstreckt sich der Kathodenbereich 5 über die gesamte Breite des Kathodenfingers 7, während die Wandschichten 14 unterhalb des Kathodenbereichs 5 im Inneren des Kathodenfingers 7 enden. Aus diesem Grunde sind hier auch keine Isolierungsschichten unterhalb der Kathodenmetallisierung 3 notwendig.

Die Wandschichten 14 sind beim Bauelement der Fig. 3B auf der Aussenseite mit isolierenden Wandabdeckungsschichten 17 (z.B. aus SiO₂) abgedeckt. Diese Massnahme, die auch beim Bauelement der Fig. 3A vorgesehen werden kann, verhindert Kurzschlüsse in den Wandschichten 14, wie sie z.B. beim Metallisieren der Kontakte auftreten können, und stellt so einen relativ hohen Widerstand sicher, der das Abführen von Löchern über die Wandschichten verhindert.

In den beiden Fällen aus Fig. 3A und 3B haben die Kathodenfinger 7 vorzugsweise eine Breite von etwa 30 $\mu$m, die Gräben eine Tiefe von etwa 35 $\mu$m, und die Wandschichten 14 eine Dicke von etwa 4 $\mu$m und eine Rand-Dotierungskonzentration von etwa 3 • 10¹⁵ cm⁻³. Diese Auslegung sichert einen besonders geringen Durchlasswiderstand der Bauelemente.

Im Ausführungsbeispiel der Fig. 3C sind die p⁺-dotierten Gatebereiche mit einer Langkanalsteuerung kombiniert, die in den Grabenwänden npn-Transistorstrukturen 16a, b aufweist. Die Transistorstrukturen 16a, b werden jeweils gebildet von der innenliegenden, n-leitenden Kanalschicht 9, von den p-leitenden Wandschichten 14 und dem n-leitenden Kathodenbereich 5, der an den Seiten des Kathodenfingers 7, die Wandschichten 14 grösstenteils bedeckend, in die Gräben herabgezogen ist.

Auch diese flächenhaften Transistorstrukturen 16a, b in den Grabenwänden verhindern wirksam das Abfliessen von Löchern über die Wandschichten, so dass auch in diesem Fall neben dem niedrigen Gatewiderstand auch ein niedriger Durchlasswiderstand des Bauelements gegeben ist.

In den bisher beschriebenen drei Ausführungsbeispielen der Fig. 3A - C waren die Bauelemente als normally-ON-FCThs ausgeführt, bei denen (wie in Fig. 3A gezeigt) die Raumladungszonen den Langkanal nicht abschnüren, wenn Gate und Kathode auf demselben Potential liegen.

Gemäss einem weiteren bevorzugten Ausführungsbeispiel der Erfindung sind die Bauelemente als normally-OFF-FCThs ausgeführt. In diesem Fall reichen bereits bei Kurzschluss zwischen Gate und Kathode die Raumladungszonen 15 soweit in das Innere des Kathodenfingers 7 hinein, dass die Elektronen nicht mehr aus der Kathode gelangen können und der Stromfluss unterbunden ist.

Das Abschnüren kann auf verschiedene Weise realisiert werden: Zum Einen können die Wandschichten 14 dicker gemacht werden, um die Raumladungszonen ins Innere des Kathodenfingers zu verschieben. Zum Zweiten kann bei gleichbleibender Dicke der Wandschichten die Breite des Kathodenfingers verringert werden, um die Raumladungszonen einander anzunähern. Und zum Dritten kann die Dotierung der Kanalschicht 9 verringert werden, um die Raumladungszonen auszuweiten. Im übrigen können diese Massnahmen auch in beliebiger Kombination angewandt werden.

Beispielhaft sei anhand der Fig. 3D hier gezeigt, wie das Bauelement aus Fig. 3A durch Verbreiterung der Wandschichten 14 dahingehend modifiziert werden kann, dass die Raumladungszonen 25 sich nunmehr in der Mitte des Kathodenfingers 7 treffen und jeglichen Elektronenstrom aus dem Kathodenbereich 5 unterbinden.

Die Trennung von Gatebereichen 8 und Wandschichten 14 macht nun auch bei der Herstellung der Bauelemente ein neues Verfahren notwendig.

Wie aus der eingangs zitierten EP-A2-0 178 387 hervorgeht, werden die Gräben zwischen den Kathodenfingern 7 durch ein anisotropes Aetzverfahren ausgehoben. Bewährt hat sich hierbei das reaktive Ionenätzen (RIE). Möglich ist aber auch ein nasschemisches Verfahren, dass die Kristallanisotropie ausnützt.

Beim bekannten RIE-Verfahren werden die Kathodenfinger durch eine Maske aus SiO₂ und einer darüberliegenden Al-Schicht abgedeckt, die nach Beendigung des Aetzprozesses einen Ueberhang aufweist, d.h. über den Grabenrand hinausragt.

Dieser Ueberhang ist bedeutungslos, wenn, wie im Stand der Technik, die Wandschichten und die Gatebereiche gemeinsam durch eine ungerichtete Diffusion in Grabenwände und -böden eingebracht werden.

Er erweist sich jedoch als nützlich, wenn erfindungsgemäss die selektive Dotierung der Gatebereiche mittels Ionenimplantation vorgenommen wird.

Ein erstes Ausführungsbeispiel des Verfahrens nach der Erfindung ist in Fig. 4A, B dargestellt. Ausgehend von einer Konfiguration, wie sie aus Fig. 7c der EP-A2-0 178 387 bekannt ist, werden hier mittels senkrechter Ioneninplantation (die Ionen treffen senkrecht auf das Halbleitersubstrat) auf den Grabenböden Implantationsgebiete 19 erzeugt (Fig. 4A). Die überhängenden Masken 18 auf den Kathodenfingern 7 schützen dabei die Grabenwände vor einer ungewollten Dotierung.

Um die Gatebereiche auch auf die Grabenekken auszudehnen, werden anschliessend in einem Drive-in-Schritt die Dotieratome aus den Implantationsgebieten 19 weiter in das Substratmaterial diffundiert, bis sich die gewünschten Geometrien der Gatebereiche 8 ergeben (Fig. 4B).

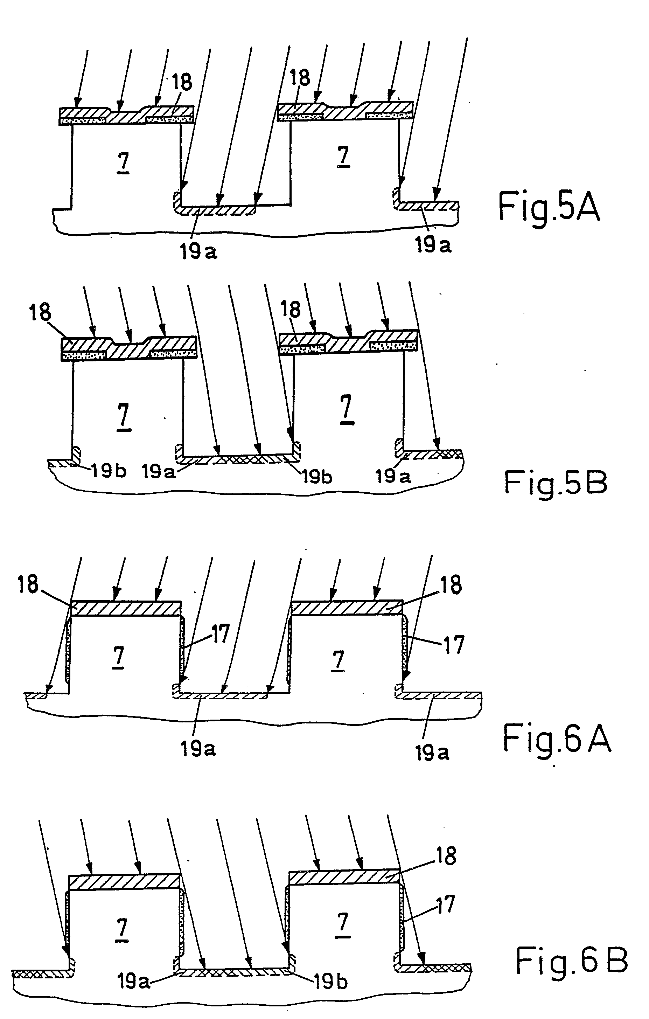

Eine noch bessere Steuerung der Diffusion erreicht man mit einem Implantationsverfahren, wie es in Fig. 5A, B wiedergegeben ist. Auch hier spielen die überhängenden Masken 18 eine wesentliche Rolle. In diesem Ausführungsbeispiel wird die Implantation in zwei Schritten durchgeführt: In dem ersten Schritt (Fig. 5A) wird durch einen schrägen Einfall der Ionen auf jedem Grabenboden ein erstes Implantationsgebiet 19a erzeugt, welches von der einen Grabenwand bis wenigstens zur Mitte des Grabenbodens reicht. Der Einfallswinkel ist dabei so gewählt, dass die Maskenüberhänge gerade den Teil der Grabenwände abschalten, der für die Wandschichten vorgesehen ist.

In dem zweiten Schritt wird durch einen genau entgegengesetzt schrägen Einfall der Ionen auf jedem Grabenboden ein zweites Implantationsgebiet 19b erzeugt, das ebenfalls wenigstens von der anderen angrenzenden Grabenwand bis zur Mitte des Grabenbodens reicht (Fig. 5B).

Beide Implantationsgebiete 19a, b bilden dann auf dem Grabenboden ein grosses, zusammenhängendes Gebiet, welches in seiner Gestalt dem endgültigen Gatebereich im wesentlichen entspricht. Auch hier kann ein Drive-in-Schritt angeschlossen werden.

Das zweischrittige Implantationsverfahren lässt sich aber auch anwenden, wenn die Masken 18 keinen Ueberhang haben, sondern mit den Grabenkanten abschliessen. In diesem Fall (Fig. 6A, B) werden die Grabenwände im Bereich der Wandschich ten direkt durch Wandabdeckungsschichten 17 geschützt, die z.B. aus $SiO_2$ bestehen.

Für die Implantation selbst werden vorzugsweise Bor-Ionen verwendet.

Insgesamt steht mit der Erfindung ein abschaltbares Leistungshalbleiterbauelement zur Verfügung, das sich durch gute Steuerbarkeit (Langkanal), hohe Abschaltströme (Gatewiderstand) und niedrigen Durchlasswiderstand (Löcher-Bypass) auszeichnet.

**Ansprüche**

1. Abschaltbares Leistungshalbleiterbauelement in Form eines Feldgesteuerten Thyristors (FCTh) mit einer Anode (A), einer Kathode (K) und einem Gate (G), umfassend zwischen der Anode (A) und der Kathode (K)

(a) eine p-leitende Anodenschicht (11);

(b) eine darüberliegende n-leitende Kanalschicht (9); und

(c) eine Mehrzahl von auf der Kathodenseite abwechselnd angeordneten n-leitenden Kathodenbereichen (5) und p-leitenden Gatebereichen (8); wobei

(d) die Kathodenbereiche (5) auf durch Gräben voneinander getrennten Kathodenfingern (7) angeordnet sind;

(e) die Gatebereiche (8) sich über die Böden der Gräben erstrecken; und

(f) im Bereich der Grabenwände zusätzlich p-leitende, p-dotierte Wandschichten (14) vorgesehen sind, welche mit den Gatebereichen (8) in Verbindung stehen, und in jedem Kathodenfinger (7) mit dem dortigen Bereich der Kanalschicht (9) einen feldeffektsteuerbaren Langkanal bilden; dadurch gekennzeichnet, dass

(g) die p-leitenden Gatebereiche (8) $p^+$-dotiert sind.

2. Abschaltbares Leistungshalbleiterbauelement nach Anspruch 1, dadurch gekennzeichnet, dass die Gatebereiche (8) eine Rand-Dotierungskonzentration grösser $10^{18}$ $cm^{-3}$, vorzugsweise etwa $10^{19}$ $cm^{-3}$, aufweisen.

3. Abschaltbares Leistungshalbleiterbauelement nach Anspruch 2, dadurch gekennzeichnet, dass

(a) die Wandschichten (14) von den Grabenwänden bis in das Innere der Kathodenfinger (7) reichen; und

(b) die Wandschichten in ihrer Dicke und Dotierungskonzentration derart dimensioniert sind, dass

(aa) bei Vollast weniger als 1/3 des Löcherstroms, der in den Kathodenfingern (7) ankommt, über die Wandschichten (14) zur Kathode (K) des Bauelements abgeführt wird; und

(bb) beim grössten auftretenden elektrischen Feld die Ladungsträger aus den Wandschichten (14) noch nicht vollständig ausgeräumt sind.

4. Abschaltbares Leistungshalbleiterbauelement nach Anspruch 3, dadurch gekennzeichnet, dass

(a) die Kathodenfinger (7) jeweils eine Breite von etwa 30 $\mu m$ aufweisen,

(b) die Gräben jeweils etwa 35 $\mu m$ tief sind; und

(c) die Wandschichten (14) jeweils eine Dicke von etwa 4 $\mu m$ und eine Rand-Dotierungskonzentration von etwa $3 \bullet 10^{15}$ $cm^{-3}$ aufweisen.

5. Abschaltbares Leistungshalbleiterbauelement nach Anspruch 3, dadurch gekennzeichnet, dass die Wandschichten (14) an den Grabenwänden durch isolierende Wandabdeckungsdichten (17) abgedeckt sind, welche vorzugsweise aus $SiO_2$ bestehen.

6. Abschaltbares Leistungshalbleiterbauelement nach Anspruch 2, dadurch gekennzeichnet, dass

(a) die Wandschichten (14) von den Gatebereichen (8) ausgehend nur bis in die Nähe der auf den Kathodenfingern (7) befindlichen Kathodenbereiche (5) reichen; und

(b) die Kathodenbereiche (5) derart erweitert sind, dass sie sich, eingelassen in die Wandschichten (14), über die Grabenwände bis in die Nähe der Gatebereiche (8) erstrecken, und zusammen mit den Wandschichten (14) und den darunterliegenden Gebieten der Kanalschicht (9) Transistorstrukturen (16a, b) bilden, welche sich über die Fläche der Grabenwände erstrecken.

7. Abschaltbares Leistungshalbleiterbauelement nach Anspruch 1, dadurch gekennzeichnet, dass die Raumladungszonen (15) der zwischen den Wandschichten (14) und der Kanalschicht (9) gebildeten pn-Uebergänge soweit in das Innere der Kathodenfinger (7) hineinreichen, dass bei einem Kurzschluss zwischen Gate (G) und Kathode (K) der Stromfluss durch die Kathodenfinger (7) unterbunden ist.

8. Verfahren zur Herstellung eines abschaltbaren Leistungshalbleiterbauelements gemäss Anspruch 1, bei welchem Verfahren zunächst durch anisotropes Aetzen in einem Halbleitersubstrat die Gräben erzeugt und anschliessend in die Grabenböden die Gatebereiche (8) eingebracht werden, dadurch gekennzeichnet, dass

(a) die Gatebereiche (8) mittels Ionenimplantation, vorzugsweise von Bor, erzeugt werden, und

(b) die Grabenwände im Bereich der späteren Wandschichten (14) während des Implantationvorganges vor einer Implantation geschützt werden.

9. Verfahren nach Anspruch 8, dadurch gekennzeichnet, dass

(a) die zu implantierenden Ionen senkrecht auf das Halbleitersubstrat auftreffen; und

(b) die Grabenwände durch eine überhängende Maske (18) auf den Kathodenfingern (7) geschützt werden.

10. Verfahren nach Anspruch 8, dadurch gekennzeichnet, dass

(a) die Implantation in zwei Schritten durchgeführt wird, wobei
(aa) in dem ersten Schritt durch einen schrägen Einfall der Ionen auf jedem Grabenboden ein erstes Implantationsgebiet (19a) erzeugt wird, welches von der einen angrenzenden Grabenwand bis wenigstens zur Mitte des Grabenbodens reicht; und
(bb) in dem zweiten Schritt durch einen entgegengesetzt schrägen Einfall der Ionen auf jedem Grabenboden ein zweites Implantationsgebiet (19b) erzeugt wird, welches von der anderen angrenzenden Grabenwand bis wenigstens zur Mitte des Grabenbodens reicht; und

(b) die Grabenwände entweder durch eine überhängende Maske (18) auf den Kathodenfingern (7) oder durch eine Wandabdeckungsschicht (17) geschützt werden.

Fig.1

Fig. 2A

Fig. 2B

87/077

Fig.3A

Fig.3C

Fig.3B

Fig.3D

Fig.4A

Fig.4B

87/077

Fig.5A

Fig.5B

Fig.6A

Fig.6B

87/077

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-2 026 237 (TEXAS INSTRUMENTS LTD) * Seite 2, Zeilen 62-80; Seite 2, Zeile 127 - Seite 3, Zeile 4; Figur 4 * --- | 1,5,8-10 | H 01 L 29/10 H 01 L 29/72 H 01 L 21/265 |
| D,P A | EP-A-0 249 122 (BBC AG BROWN, BOVERI & CIE) * Seite 3, Zeile 40 - Seite 4, Zeile 39; Seite 5, Zeilen 5-28; Figuren 3A,3C * --- | 1,3-6 | |
| A | PATENT ABSTRACTS OF JAPAN, Band 6, Nr. 64 (E-103)[942], 23. April 1982; & JP-A-575 359 (HITACHI SEISAKUSHO K.K.) 12-01-1982 * Zusammenfassung; Figuren * --- | 1,5,6 | |
| D,A | EP-A-0 121 068 (BBC AG BROWN, BOVERI & CIE) * Seite 8, Zeilen 12-14; Figur 2 * --- | 1,2 | |
| A | EP-A-0 029 932 (GENERAL ELECTRIC CO.) * Seite 9, Zeilen 18-25; Seite 11, Zeilen 13-16; Seite 13, Zeilen 1-9; Figur 2A * --- | 1,2,7 | RECHERCHIERTE SACHGEBIETE (Int. Cl.4) H 01 L |
| A | US-A-4 262 296 (SHEALY et al.) * Spalte 6, Zeilen 10-18; Figuren 13,14 * --- | 1,8,10 | |
| D,A | EP-A-0 178 387 (BBC AG BROWN, BOVERI & CIE) * Seite 7, Zeilen 12-19; Seite 8, Zeile 33 - Seite 9, Zeile 12; Figuren 1,2,7e * ----- | 1,3,4,9,10 | |

Der vorliegende Recherchenbericht wurde für alle Patentansprüche erstellt

| Recherchenort | Abschlußdatum der Recherche | Prüfer |
|---|---|---|
| DEN HAAG | 02-03-1989 | MORVAN D.L.D. |